# EUROPEAN PATENT SPECIFICATION

(11) **EP 4 174 429 B1**
(45) Date of publication and mention of the grant of the patent: **03.04.2024**
(21) Application number: 22204677.3
(22) Date of filing: 31.10.2022
(51) Int. Cl.: F28D 15/02, H05K 7/20

(54) **ELECTRONIC DEVICE**
ELEKTRONISCHE VORRICHTUNG
DISPOSITIF ÉLECTRONIQUE

(30) Priority: 02.11.2021 JP 2021179446
(43) Date of publication of application: 03.05.2023
(73) Proprietor: SHINKO ELECTRIC INDUSTRIES CO., LTD., Nagano-shi, Nagano 381-2287 (JP)
(72) Inventor: MACHIDA, Yoshihiro, Nagano, 381-2287 (JP)
(74) Representative: Zimmermann & Partner Patentanwälte mbB

(56) References cited:
- EP-A1- 3 460 375
- US-A1- 2019 115 281

## Description

### TECHNICAL FIELD

The present invention relates to an electronic device. An electronic device comprising a loop type heat pipe including a loop-shaped flow path in which a working fluid is enclosed is known from document EP 3 460 375, which can be considered as the closest prior art.

### BACKGROUND ART

In the related art, as a device configured to cool a heat-generating component of a semiconductor device (for example, a CPU or the like) mounted on an electronic device, suggested is a heat pipe configured to transport heat by using a phase change of a working fluid (for example, refer to Patent Literatures 1 and 2).

As an example of the heat pipe, known is a loop type heat pipe including an evaporator configured to vaporize a working fluid by heat of a heat-generating component and a condenser configured to cool and condense the vaporized working fluid, in which the evaporator and the condenser are connected by a liquid pipe and a vapor pipe configured to form a loop-shaped flow path. In the loop type heat pipe, the working fluid flows in one direction in the loop-shaped flow path.

### CITATION LIST

### PATENT LITERATURE

Patent Literature 1: JP6291000B
Patent Literature 2: JP6400240B

### SUMMARY OF INVENTION

In the meantime, in the loop type heat pipe, it is desired to be able to vary heat dissipation performance (cooling performance) according to a use situation, a use environment, and the like, and in this respect, there is still room for improvement.

Certain embodiment provides an electronic device.

The electronic device comprises:
a loop type heat pipe including a loop-shaped flow path in which a working fluid is enclosed;
a first magnet provided to the loop type heat pipe;
a heat dissipation plate thermally connectable to the loop type heat pipe;
a second magnet provided to the heat dissipation plate and provided to face the first magnet; and
a support member that movably supports the heat dissipation plate so that a distance between the loop type heat pipe and the heat dissipation plate can be varied in response to a change in magnetic force of the first magnet.

According to one aspect of the present invention, the effect capable of varying the heat dissipation performance is exhibited.

### BRIEF DESCRIPTION OF DRAWINGS

In the following, embodiments are described with reference to the Figures without being limited thereto.
FIG. 1A is a schematic cross-sectional view (a cross-sectional view taken along a line 1-1 in FIG. 3) showing an electronic device of one embodiment.
FIG. 1B is an enlarged cross-sectional view of a part of the electronic device shown in FIG. 1A.
FIG. 2 is a schematic cross-sectional view showing the electronic device of one embodiment.
FIG. 3 is a schematic plan view showing the electronic device of one embodiment.
FIG. 4 is a schematic cross-sectional view showing the electronic device of one embodiment.
FIG. 5 is a schematic cross-sectional view showing an electronic device of a modified embodiment.
FIG. 6 is a schematic cross-sectional view showing an electronic device of a modified embodiment.
FIG. 7 is a schematic cross-sectional view showing an electronic device of a modified embodiment.
FIG. 8 is a schematic cross-sectional view showing an electronic device of a modified embodiment.
FIG. 9 is a schematic cross-sectional view showing an electronic device of a modified embodiment.
FIG. 10 is a schematic plan view showing an electronic device of a modified embodiment.

### DESCRIPTION OF EMBODIMENTS

Hereinafter, one embodiment will be described with reference to the accompanying drawings.

Note that, for convenience sake, in the accompanying drawings, a characteristic part is enlarged so as to easily understand the feature, and the dimension ratios of the respective constitutional elements may be different in the respective drawings. Further, in the cross-sectional views, hatching of some members is shown in a satin form and hatching of some members is omitted, so as to easily understand a sectional structure of each member. In the respective drawings, an X-axis, a Y-axis, and a Z-axis orthogonal to each other are shown. In descriptions below, for convenience sake, a direction extending along the X-axis is referred to as 'X-axis direction', a direction extending along the Y-axis is referred to as 'Y-axis direction', and a direction extending along the Z-axis is referred to as 'Z-axis direction'. Note that, in the present specification, 'in a top view' means seeing a target object in the Z-axis direction, and 'planar shape' means a shape of a target object as seen in the Z-axis direction.

### (Overall Configuration of Electronic Device M1)

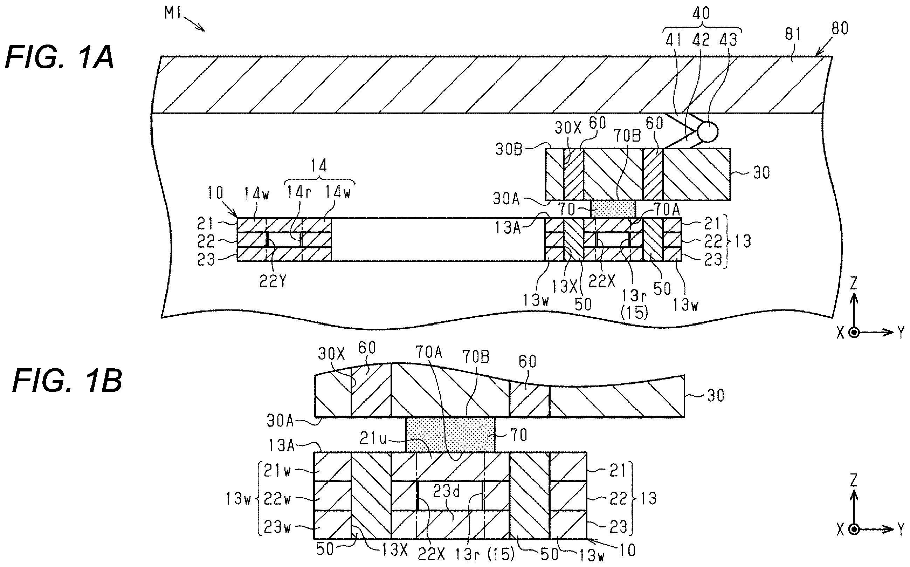

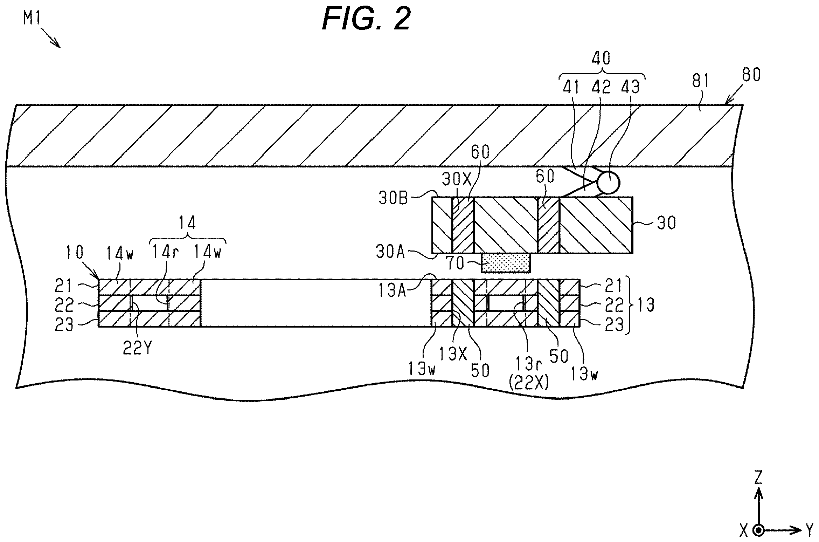

As shown in FIGS. 1A and 2, an electronic device M1 includes a loop type heat pipe 10, a heat dissipation plate 30 thermally connectable to an outer surface of the loop type heat pipe 10, and a support member 40 configured to movably support the heat dissipation plate 30. The electronic device M1 includes a first magnet 50 provided in the loop type heat pipe 10 and a second magnet 60 provided in the heat dissipation plate 30. The electronic device M1 includes, for example, a heat conductive member 70 provided between the loop type heat pipe 10 and the heat dissipation plate 30, and a housing 80.

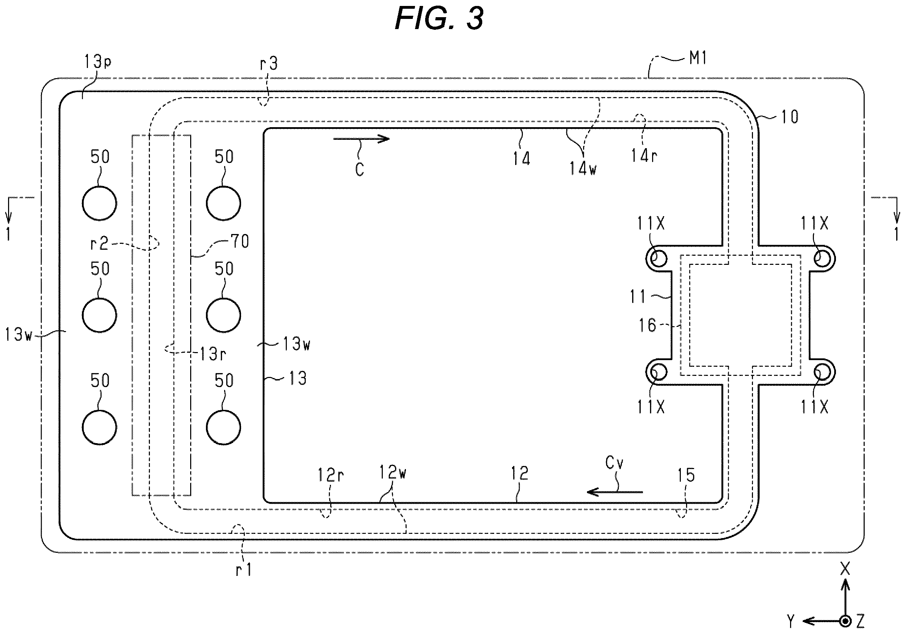

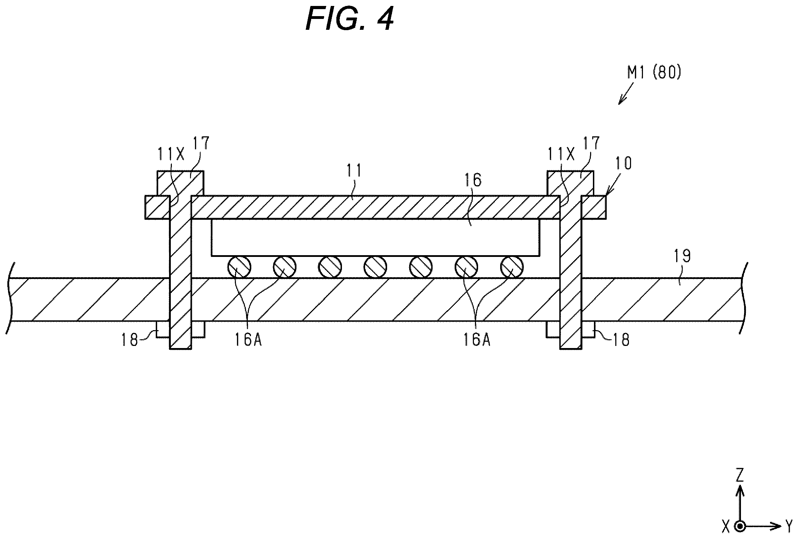

As shown in FIGS. 3 and 4, the electronic device M1 includes, for example, a heat-generating component 16 thermally connected to the loop type heat pipe 10. As shown in FIG. 4, the electronic device M1 includes, for example, a wiring substrate 19 on which the heat-generating component 16 is mounted. The electronic device M1 is, for example, an electronic device on which the heat-generating component 16 and a device for cooling the heat-generating component 16 are mounted. As the device for cooling the heat-generating component 16, known is a heat pipe configured to transport heat by using a phase change of a working fluid. As an example of the heat pipe, the loop type heat pipe 10 may be exemplified.

As shown in FIGS. 1A and 2, in the electronic device M1, the heat dissipation plate 30 is movably supported by the support member 40 so that a distance between the outer surface of the loop type heat pipe 10 and the heat dissipation plate 30 can be varied in response to a change in magnetic force of the first magnet 50. At this time, the heat dissipation plate 30 is supported to be movable in the Z-axis direction between a state in which the heat dissipation plate is thermally connected to the outer surface of the loop type heat pipe 10 (refer to FIA.1A) and a state in which the heat dissipation plate is not thermally connected to the outer surface of the loop type heat pipe 10 (refer to FIG. 2).

### (Configuration of Housing 80)

The housing 80 is formed in a box shape. The housing 80 has, for example, a plurality of wall parts 81. Note that, in FIGS. 1A and 2, only one wall part 81 of the plurality of wall parts 81 is shown. The housing 80 has a structure closed by the plurality of wall parts 81. The housing 80 is configured to accommodate, for example, electronic components such as the heat-generating component 16 (refer to FIG. 4) and the wiring substrate 19 (refer to FIG. 4), the loop type heat pipe 10, the heat dissipation plate 30, the support member 40, the first magnet 50, the second magnet 60, and the heat conductive member 70.

### (Configuration of Loop Type Heat Pipe 10)

As shown in FIG. 3, the loop type heat pipe 10 includes an evaporator 11, a vapor pipe 12, a condenser 13 and a liquid pipe 14.

The evaporator 11 and the condenser 13 are connected by the vapor pipe 12 and the liquid pipe 14. The evaporator 11 has a function of vaporizing a working fluid C to generate vapor Cv. The vapor Cv generated in the evaporator 11 is sent to the condenser 13 via the vapor pipe 12. The condenser 13 has a function of condensing the vapor Cv of the working fluid C. The condensed working fluid C is sent to the evaporator 11 via the liquid pipe 14. The vapor pipe 12 and the liquid pipe 14 are configured to form a loop-shaped flow path 15 through which the working fluid C or the vapor Cv is caused to flow. In the flow path 15, the working fluid C is enclosed.

The vapor pipe 12 is formed, for example, by an elongated pipe body. The liquid pipe 14 is formed, for example, by an elongated pipe body. In the present embodiment, the vapor pipe 12 and the liquid pipe 14 are the same in dimension (i.e., length) in a length direction, for example. Note that, the length of the vapor pipe 12 and the length of the liquid pipe 14 may be different from each other. For example, the length of the vapor pipe 12 may be shorter than the length of the liquid pipe 14. Here, in the present specification, the 'length direction' of the evaporator 11, the vapor pipe 12, the condenser 13 and the liquid pipe 14 is a direction that coincides with a direction (refer to an arrow in the drawing) in which the working fluid C or vapor Cv flows in each member. In addition, in the present specification, the 'same' includes not only a case where comparison targets are exactly the same but also a case where there is a slight difference between the comparison targets due to influences of dimensional tolerances and the like.

As shown in FIG. 4, the evaporator 11 is fixed in close contact with the heat-generating component 16. The evaporator 11 is fixed to an upper surface of the heat-generating component 16, for example. The evaporator 11 has, for example, a plurality of (four, in the present embodiment) attaching holes 11X. Each attaching hole 11X is formed to penetrate through the evaporator 11 in a thickness direction (here, Z-axis direction). The evaporator 11 is fixed to the wiring substrate 19 by, for example, a screw 17 inserted in each attaching hole 11X and a nut 18 screwed onto the screw 17. The heat-generating component 16 is mounted on the wiring substrate 19. The heat-generating component 16 is mounted on the wiring substrate 19 by bumps 16A, for example. A lower surface of the evaporator 11 is in close contact with the upper surface of the heat-generating component 16. As the heat-generating component 16, for example, a semiconductor device such as a CPU (Central Processing Unit) chip or a GPU (Graphics Processing Unit) chip may be used.

As shown in FIG. 3, the working fluid C in the evaporator 11 is vaporized by heat generated by the heat-generating component 16, and vapor Cv is accordingly generated. The vapor Cv generated in the evaporator 11 is introduced into the condenser 13 via the vapor pipe 12.

The vapor pipe 12 has a pair of pipe walls 12w provided on both sides in a width direction orthogonal to the length direction of the evaporator 12, in a top view, and a flow path 12r provided between the pair of pipe walls 12w, for example. The flow path 12r is formed to communicate with an internal space of the evaporator 11. The flow path 12r is a part of the loop-shaped flow path 15.

The condenser 13 has a heat dissipation plate 13p whose area is increased for heat dissipation, and a flow path 13r provided in the heat dissipation plate 13p, for example. The flow path 13r has a flow path r1 formed to communicate with the flow path 12r and extending in the Y-axis direction, a flow path r2 bent from the flow path r1 and extending in the X-axis direction, and a flow path r3 bent from the flow path r2 and extending in the Y-axis direction. The flow path 13r (flow paths r1 to r3) is a part of the loop-shaped flow path 15. The condenser 13 has pipe walls 13w provided on both sides in a direction orthogonal to a length direction of the flow path 13r, i.e., flow paths r1 to r3, in the top view. The vapor Cv introduced via the vapor pipe 12 is condensed in the condenser 33. The working fluid C condensed in the condenser 13 is guided to the evaporator 11 through the liquid pipe 14.

The liquid pipe 14 has a pair of pipe walls 14w provided on both sides in the width direction orthogonal to the length direction of the liquid pipe 14, in the top view, and a flow path 14r provided between the pair of pipe walls 14w, for example. The flow path 14r is formed to communicate with the flow path 13r (specifically, the flow path r3) of the condenser 13 and the internal space of the evaporator 11. The flow path 14r is a part of the loop-shaped flow path 15.

In the loop type heat pipe 10, the heat generated by the heat-generating component 16 is transferred to the condenser 13 and dissipated in the condenser 13. Thereby, the heat-generating component is 16 is cooled, and the temperature rise of the heat-generating component 16 is suppressed.

Here, as the working fluid C, a fluid having a high vapor pressure and a high latent heat of vaporization is preferably used. By using such working fluid C, it is possible to effectively cool the heat-generating component 16 by the latent heat of vaporization. As the working fluid C, ammonia, water, freon, alcohol, acetone or the like can be used, for example.

### (Specific Structure of Condenser 13)

FIGS. 1A and 2 show a cross section of the loop type heat pipe 10 taken along a line 1-1 of FIG. 3. This cross section is a plane orthogonal to the direction in which the working fluid C flows in the condenser 13 and the liquid pipe 14.

As shown in FIGS. 1A and 2, the condenser 13 has a structure where metal layers 21, 22 and 23 of three layers, for example, are stacked. In other words, the condenser 13 has a structure where the metal layer 22, which is an inner metal layer, is stacked between the metal layers 21 and 23, which are a pair of outer metal layers. The inner metal layer of the condenser 13 of the present embodiment is configured by only one metal layer 22.

Each of the metal layers 21 to 23 is a copper (Cu) layer having excellent thermal conductivity. The plurality of metal layers 21 to 23 are directly bonded to each other by solid-phase bonding such as diffusion bonding, pressure welding, friction pressure welding and ultrasonic bonding. Note that, in FIGS. 1A, 1B and 2, the metal layers 21 to 23 are identified by solid lines for easy understanding. For example, when the metal layers 21 to 23 are integrated by diffusion bonding, interfaces of the respective metal layers 21 to 23 may be lost and boundaries may not be clear. As used herein, the solid-phase bonding is a method of heating and softening bonding target objects in a solid-phase (solid) state without melting the same, and then further heating, plastically deforming and bonding the bonding target objects. Note that, the metal layers 21 to 23 are not limited to the copper layers and may also be formed of stainless steel, aluminum, magnesium alloy or the like. In addition, for some of the stacked metal layers 21 to 23, a material different from the other metal layers may also be used. A thickness of each of the metal layers 21 to 23 may be set to about 50µm to 200µm, for example. Note that, some of the metal layers 21 to 23 may be each formed to have a thickness different from the other metal layers, and all the metal layers may be formed to have thicknesses different from each other.

As shown in FIG. 1B, the condenser 13 is configured by the metal layers 21 to 23 stacked in the Z-axis direction, and has the flow path 13r and the pair of pipe walls 13w provided on both sides of the flow path 13r in the Y-axis direction.

The metal layer 22 is stacked between the metal layer 21 and the metal layer 23. An upper surface of the metal layer 22 is bonded to the metal layer 21. A lower surface of the metal layer 22 is bonded to the metal layer 23. The metal layer 22 has a through-hole 22X penetrating through the metal layer 22 in the thickness direction, and a pair of pipe walls 22w provided on both sides of the through-hole 22X in the Y-axis direction. The through-hole 22X constitutes the flow path 13r.

The metal layer 21 is stacked on the upper surface of the metal layer 22. The metal layer 21 has pipe walls 21w provided at positions overlapping the pipe walls 22w in the top view, and an upper wall 21u provided at a position overlapping the flow path 13r, for example the through-hole 22X, in the top view. A lower surface of the pipe wall 21w is bonded to an upper surface of the pipe wall 22w. The upper wall 21u is provided and extends between the pair of pipe walls 21w. A lower surface of the upper wall 21u is exposed to the flow path 13r. In other words, the upper wall 21u constitutes the flow path 13r.

The metal layer 23 is stacked on the lower surface of the metal layer 22. The metal layer 23 has pipe walls 23w provided at positions overlapping the pipe walls 22w in the top view, and a lower wall 23d provided at a position overlapping the flow path 13r, for example the through-hole 22X, in the top view. An upper surface of the pipe wall 23w is bonded to a lower surface of the pipe wall 22w. The lower wall 23d is provided and extends between the pair of pipe walls 23w. An upper surface of the lower wall 23d is exposed to the flow path 13r. In other words, the lower wall 23d constitutes the flow path 13r.

The flow path 13r is configured by the through-hole 22X of the metal layer 22. The flow path 13r is formed by a space surrounded by an inner wall surface of the through-hole 22X, the lower surface of the upper wall 21u, and the upper surface of the lower wall 23d.

Each pipe wall 13w is configured by, for example, the pipe wall 21w of the metal layer 21, the pipe wall 22w of the metal layer 22, and the pipe wall 23w of the metal layer 23.

As shown in FIG. 1A, the condenser 13 has a first facing surface 13A facing the heat dissipation plate 30. The first facing surface 13A is configured by, for example, the upper surface of the metal layer 21 in the condenser 13. Note that, in the present specification, 'facing' indicates that surfaces or members are located at positions facing each other, and includes not only a case where they are located at positions completely facing each other, but also a case where they are located at positions partially facing each other. Also, in the present specification, 'facing' includes both a case where a member different from two parts is interposed between the two parts and a case where no member is interposed between the two parts.

### (Configuration of Vapor pipe 12)

Similar to the condenser 13 shown in FIGS. 1A, 1B and 2, the vapor pipe 12 shown in FIG. 3 is formed by the three stacked metal layers 21 to 23 (refer to FIGS. 1A and 2). For example, in the vapor pipe 12, the flow path 12r is formed by forming a through-hole penetrating through the metal layer 22, which is an inner metal layer, in the thickness direction.

### (Configuration of Liquid Pipe 14)

FIGS. 1A and 2, the liquid pipe 14 is formed by the three stacked metal layers 21 to 23, similar to the condenser 13. In the liquid pipe 14, the flow path 14r is formed by forming a through-hole 22Y penetrating through the metal layer 22, which is an inner metal layer, in the thickness direction. The liquid pipe 14 has the pair of pipe walls 14w provided on both sides of the flow path 14r. Each pipe wall 14w is not formed with a hole or a groove. The liquid pipe 14 may have a porous body, for example. The porous body is configured to have, for example, first bottomed holes concave from the upper surface of the metal layer 22, which is an inner metal layer, second bottomed holes concave from the lower surface of the metal layer 22, and pores formed by causing the first bottomed holes and the second bottomed holes to partially communicate with each other. The porous body is configured to guide the working fluid C condensed in the condenser 13 to the evaporator (refer to FIG. 3) by a capillary force generated in the porous body 20, for example. In addition, although not shown, the liquid pipe 14 is provided with an injection port for injecting the working fluid C (refer to FIG. 3). However, the injection port is closed by a sealing member, so that an inside of the loop type heat pipe 10 is kept airtight.

### (Configuration of Evaporator 11)

Similar to the condenser 13 shown in FIGS. 1A, 1B and 2, the evaporator 11 shown in FIG. 3 is formed by the three stacked metal layers 21 to 23 (refer to FIGS. 1A and 2). The evaporator 11 may have a porous body, similar to the liquid pipe 14, for example. For example, in the evaporator 11, a porous body provided in the evaporator 11 is formed in a comb-teeth shape. In the evaporator 11, a region in which the porous body is not provided has a space.

In this way, the loop type heat pipe 10 is configured by the three stacked metal layers 21 to 23 (refer to FIG the.2A). Note that, the number of the stacked metal layers is not limited to three layers, and may be four or more layers.

### (Configuration of First Magnet 50)

The first magnet 50 is provided in the condenser 13 of the loop type heat pipe 10. The condenser 13 is provided with, for example, a plurality of (six, in the present embodiment) first magnets 50. Each of the first magnets 50 is embedded in the condenser 13, for example. Each of the first magnets 50 is embedded in the pipe wall 13w of the condenser 13, for example. In other words, each of the first magnets 50 is provided so as not to overlap the flow path 15, specifically, the flow path 13r, in the top view, for example. The first magnets 50 are provided, for example, on both sides of the pair of pipe walls 13w.

As shown in FIG. 1B, each of the first magnets 50 is provided to penetrate through the pipe wall 13w of the condenser 13 in the thickness direction (here, Z-axis direction), for example. For example, the pipe wall 13w is provided with a plurality of through-holes 13X penetrating through the pipe wall 13w in the thickness direction. Each of the first magnets 50 is accommodated in each through-hole 13X, for example. A side surface of each of the first magnets 50 is in close contact with an inner surface of each through-hole 13X, for example. The side surface of each of the first magnets 50 is in close contact with the inner surface of each through-hole 13X over an entire circumference of the first magnet 50 in a circumferential direction, for example. Note that, the side surface of each of the first magnets 50 and the inner surface of each through-hole 13X may be in direct contact with each other or may be in contact with each other via an adhesive member or the like. An upper surface of each of the first magnets 50 is exposed from, for example, the upper surface of the metal layer 21, i.e., the first facing surface 13A. The upper surface of each of the first magnets 50 is formed flush with the first facing surface 13A, for example. A lower surface of each of the first magnets 50 is exposed from the lower surface of the metal layer 23, for example. The lower surface of each of the first magnets 50 is formed flush with the lower surface of the metal layer 23, for example.

A planar shape of each of the first magnets 50 can be formed to have arbitrary shape and size. As shown in FIG. 3, the planar shape of each of the first magnets 50 of the present embodiment is formed in a circular shape. The plurality of first magnets 50 are provided side by side along one direction (here, X-axis direction) of a plane direction orthogonal to the thickness direction (here, Z-axis direction) of the condenser 13. The plurality of first magnets 50 are provided spaced apart from each other in the X-axis direction, for example. In the condenser 13 of the present embodiment, on each of both sides of the flow path 13r (specifically, flow path r2) in the Y-axis direction, three first magnets 50 are provided spaced apart from each other in the X-axis direction. The first magnet 50 provided on one pipe wall 13w and the first magnet 50 provided on the other pipe wall 13w are provided to sandwich the flow path 13r from both sides in the Y-axis direction. For example, the first magnet 50 provided on one pipe wall 13w and the first magnet 50 provided on the other pipe wall 13w are provided at the same positions in the X-axis direction. Note that, the first magnet 50 provided on one pipe wall 13w and the first magnet 50 provided on the other pipe wall 13w may be provided at positions different from each other in the X-axis direction.

As the first magnet 50, for example, a ferrite magnet, a neodymium magnet, or the like can be used. As the first magnet 50, for example, it is preferably to use a magnet with relatively large demagnetization (reduction in magnetic force) due to heat, i.e., relatively large thermal demagnetization. The first magnet 50 of the present embodiment is a ferrite magnet with large thermal demagnetization.

### (Configuration of Heat Dissipation Plate 30)

As shown in FIG. 1A, the heat dissipation plate 30 is provided facing the condenser 13 of the loop type heat pipe 10. That is, the heat dissipation plate 30 is provided at a position overlapping the condenser 13, in the top view. The heat dissipation plate 30 is provided thermally connectable to the first facing surface 13A of the condenser 13, for example. The heat dissipation plate 30 is formed in a flat plate shape, for example. The heat dissipation plate 30 has a rectangular shape in the top view, for example. The planar shape of the heat dissipation plate 30 is formed larger than the planar shape of the condenser 13, for example. The heat dissipation plate 30 is also called a heat spreader. The heat dissipation plate 30 has, for example, a function of dispersing a density of heat from the condenser 13 when the heat dissipation plate is thermally connected to the first facing surface 13 A of the condenser 13.

As a material of the heat dissipation plate 30, a material having favorable thermal conductivity may be used, for example. As the heat dissipation plate 30, a substrate made of copper (Cu), silver (Ag), aluminum (Al) or an alloy thereof can be used. As the heat dissipation plate 30, for example, a substrate made of ceramics such as alumina or aluminum nitride, or an insulating material or semiconductor material having high thermal conductivity such as silicon may also be used. Note that, a thickness of the heat dissipation plate 30 may be set to about 500µm to 1000µm, for example. The thickness of the heat dissipation plate 30 is formed thicker than an overall thickness of the loop type heat pipe 10, for example.

The heat dissipation plate 30 has a second facing surface 30A (here, a lower surface) facing the first facing surface 13A of the condenser 13, and an opposite surface 30B (here, an upper surface) provided on an opposite side to the second facing surface 30A in the thickness direction (here, Z-axis direction) of the heat dissipation plate 30. The second facing surface 30A faces the first facing surface 13A in the Z-axis direction. The second facing surface 30A is thermally connectable to the first facing surface 13A via, for example, the heat conductive member 70.

### (Configuration of Second Magnet 60)

The second magnets 60 is provided in the heat dissipation plate 30. The heat dissipation plate 30 is provided with, for example, a plurality of second magnets 60. The heat dissipation plate 30 is provided with the same number (here, six) of second magnets 60 as the first magnets 50. Each of the second magnets 60 is embedded in the heat dissipation plate 30, for example. Each of the second magnets 60 is provided to face each of the first magnets 50 in the Z-axis direction. A planar shape of each of the second magnets 60 can be formed to have arbitrary shape and size. The planar shape of each of the second magnets 60 is formed in a circular shape, for example, similar to the planar shape of the first magnet 50.

Each of the second magnets 60 is provided to penetrate through the heat dissipation plate 30 in the thickness direction, for example. For example, the heat dissipation plate 30 is provided with a plurality of through-holes 30X penetrating through the heat dissipation plate 30 in the thickness direction. Each of the second magnets 60 is accommodated in each through-hole 30X, for example. A side surface of each of the second magnets 60 is in close contact with an inner surface of each through-hole 30X, for example. The side surface of each of the second magnets 60 is in close contact with the inner surface of each through-hole 30X over an entire circumference of the second magnet 60 in a circumferential direction, for example. A lower surface of each of the second magnets 60 is exposed, for example, from the second facing surface 30A. The lower surface of each of the second magnets 60 is formed flush with the second facing surface 30A, for example. An upper surface of each of the second magnets 60 is exposed from the opposite surface 30B of the heat dissipation plate 30, for example. The upper surface of each of the second magnets 60 is formed flush with the opposite surface 30B, for example.

The first magnet 50 and the second magnet 60 are provided such that the same magnetic poles face each other, for example. For example, the first magnet 50 and the second magnet 60 are provided such that an N pole of the first magnet 50 and an N pole of the second magnet 60 face each other. In the present embodiment, the N pole is magnetized on an upper part of the first magnet 50 and the N pole is magnetized on a lower part of the second magnet 60. For this reason, when the upper part of the first magnet 50 and the lower part of the second magnet 60 come close to each other, a magnetic repulsive force with which the first magnet 50 and the second magnet 60 try to move away from each other is generated between the first magnet 50 and the second magnet 60. Note that, the first magnet 50 and the second magnet 60 may also be provided such that an S pole of the first magnet 50 and an S pole of the second magnet 60 face each other.

As the second magnet 60, for example, a ferrite magnet, a neodymium magnet, or the like can be used. As the second magnet 60, for example, a magnet having relatively large thermal demagnetization can be used. The second magnet 60 may be a magnet of the same type as the first magnet 50 or a magnet different from the first magnet 50. The second magnet 60 of the present embodiment is a ferrite magnet having large thermal demagnetization.

### (Configuration of Heat Conductive Member 70)

As a material of the heat conductive member 70, for example, a heat conductive material (TIM: Thermal Interface Material) can be used. As the material of the heat conductive member 70, for example, soft metal such as indium (In) or silver, silicone gel or an organic resin binder containing a metal filler, graphite, or the like can be used.

As shown in FG. 1B, the heat conductive member 70 has a first end face 70A facing the first facing surface 13 A of the condenser 13, and a second end face 70B facing the second facing surface 30A of the heat dissipation plate 30. The heat conductive member 70 is formed so that an adhesive force of the first end face 70A and an adhesive force of the second end face 70B are different from each other, for example. For example, any one of the first end face 70A and the second end face 70B is an adhesive surface, and the other of the first end face 70A and the second end face 70B is a non-adhesive surface. In the heat conductive member 70 of the present embodiment, while the first end face 70A is formed as the non-adhesive surface, the second end face 70B is formed as the adhesive surface. For this reason, the second end face 70B of the heat conductive member 70 adheres to the second facing surface 30A of the heat dissipation plate 30. The first end face 70A of the heat conductive member 70 does not adhere to the first facing surface 13 A of the condenser 13. However, the first end face 70A of the heat conductive member 70 can contact the first facing surface 13A so as to be thermally connectable to the first facing surface 13A of the condenser 13. Note that, a thickness of the heat conductive member plate 70 may be set to about 20µm to 100µm, for example.

The heat conductive member 70 is provided, for example, on a part of the second facing surface 30A. The heat conductive member 70 is provided so as not to overlap the first magnet 50 in the top view, for example. The heat conductive member 70 is provided so as not to overlap the second magnet 60 in the top view, for example. The heat conductive member 70 is provided to overlap the flow path 13r in the top view, for example. As shown in FIG. 3, the heat conductive member 70 is provided to extend in the X-axis direction along the flow path r2 of the flow path 13r, for example. The heat conductive member 70 is provided to be sandwiched between the first magnets 50 of two rows in the Y-axis direction, for example.

### (Configuration of Support Member 40)

The electronic device M1 shown in FIGS. 1A and 2 has the plurality of support members 40, for example. The plurality of support members 40 are configured to support the heat dissipation plate 30 at a plurality of locations, for example, in the top view. In FIGS. 1A and 2, only one support member 40 of the plurality of support members 40 is shown. Each of the support members 40 is connected to the housing 80, for example. Each of the support members 40 is supported by the wall part 81 of the housing 80, for example. The support member 40 is configured to support the heat dissipation plate 30 so as to be movable in the Z-axis direction. The support member 40 is configured to support the heat dissipation plate 30 so as to be movable in the Z-axis direction between a state in which the heat dissipation plate 30 is thermally connected to the condenser 13 (refer to FIG. 1A) and a state in which the heat dissipation plate 30 is not thermally connected to the condenser 13 (refer to FIG. 2). The support member 40 is configured to movably support the heat dissipation plate 30, so as to be able to vary a distance between the first facing surface 13A of the condenser 13 and the second facing surface 30A of the heat dissipation plate 30 in response to a change in magnetic force of the first magnet 50. The support member 40 is configured to support the heat dissipation plate 30 so as to be movable in the Z-axis direction, in response to a change in repulsive force between the first magnet 50 and the second magnet 60 due to thermal demagnetization, for example. The support member 40 is configured to support the heat dissipation plate 30 so as to be parallel to the wall part 81, for example. The support member 40 is configured to support the heat dissipation plate 30 so as to be movable in the Z-axis direction while maintaining a posture in which the opposite surface 30B of the heat dissipation plate 30 is parallel to a lower surface of the wall part 81, for example. The support member 40 is configured to support the heat dissipation plate 30 so as to be parallel to the condenser 13, for example. The support member 40 is configured to support the heat dissipation plate 30 so as to be movable in the Z-axis direction while maintaining a posture in which the second facing surface 30A of the heat dissipation plate 30 is parallel to the first facing surface 13A of the condenser 13, for example. The support member 40 has, for example, a Sarrus link mechanism.

Each of the supporting members 40 has, for example, a first plate part 41, a second plate part 42, and a hinge part 43 configured to connect the first plate part 41 and the second plate part 42. An upper end of the first plate part 41 is connected to the wall part 81 of the housing 80. The upper end of the first plate part 41 is rotatably connected to the wall part 81, for example. A lower end of the first plate part 41 is connected to the hinge part 43. The lower end of the first plate part 41 is rotatably connected to the hinge part 43, for example. An upper end of the second plate part 42 is connected to the hinge part 43. The upper end of the second plate part 42 is rotatably connected to the hinge part 43. A lower end of the second plate part 42 is connected to the opposite surface 30B of the heat dissipation plate 30. The lower end of the second plate part 42 is rotatably connected to the opposite surface 30B, for example. The first plate part 41 is formed to have the same length as that of the second plate part 42, for example. Each of the support members 40 is formed so as to be able to vary an angle of the hinge part 43, i.e., an angle formed by the first plate part 41 and the second plate part 42, in response to a magnitude of the repulsive force between the first magnet 50 and the second magnet 60. For example, in response to the magnitude of the repulsive force between the first magnet 50 and the second magnet 60, the first plate part 41 rotates with respect to the wall part 81 and the hinge part 43, and the second plate part 42 rotates with respect to the heat dissipation plate 30 and the hinge part 43, so that the angle of the hinge part 43 changes. When the angle of the hinge part 43 changes, the heat dissipation plate 30 supported horizontally with respect to the wall part 81 moves in parallel along the Z-axis direction. For example, when the angle of the hinge part 43 becomes small, the heat dissipation plate 30 moves in parallel along the Z-axis direction so that it comes close to the wall part 81. For this reason, when the angle of the hinge part 43 becomes small, the heat dissipation plate 30 moves in parallel along the Z-axis direction so that it gets away from the condenser 13. In addition, when the angle of the hinge part 43 becomes large, the heat dissipation plate 30 moves in parallel along the Z-axis direction so that it gets away from the wall part 81. For this reason, when the angle of the hinge part 43 becomes large, the heat dissipation plate 30 moves in parallel along the Z-axis direction so that it comes close to the condenser 13. By the above, the heat dissipation plate 30 moves in parallel along the Z-axis direction while the posture in which the second facing surface 30A of the heat dissipation plate 30 is parallel to the first facing surface 13 A of the condenser 13 is maintained. As a result, in response to the magnitude of the repulsive force between the first magnet 50 and the second magnet 60, the distance between the first facing surface 13A and the second facing surface 30A can vary.

### (Operations of Electronic Device M1)

Next, operations of the electronic device M1 will be described.

First, referring to FIG. 2, the electronic device M1 at a time of a low heat input in which a heat input amount from the heat-generating component 16 (refer to FIG. 3) to the loop type heat pipe 10 is equal to or less than a first heat amount will be described. Here, the heat input amount (first heat amount) at the time of the low heat input is, for example, a heat amount within a range in which heat dissipation by the heat dissipation plate 30 is not required. For example, the heat input amount (first heat amount) at the time of the low heat input is a heat amount within a range in which the heat generated by the heat-generating component 16 (refer to FIG. 3) does not exceed a heat tolerance of the heat-generating component 16 even in a state in which there is no heat dissipation by the heat dissipation plate 30.

At the time of the low heat input, since the heat input amount to the condenser 13 becomes small, an ambient temperature of the first magnet 50 provided in the condenser 13 becomes relatively low. For this reason, the thermal demagnetization in the first magnet 50 does not occur, or the thermal demagnetization in the first magnet 50 is extremely small. As a result, a large repulsive force is generated between the first magnet 50 and the second magnet 60. In response to the repulsive force between the first magnet 50 and the second magnet 60, the support member 40 supports the heat dissipation plate 30 in a state of being apart from the condenser 13. Specifically, when the repulsive force generated between the first magnet 50 and the second magnet 60 becomes large, the angle of the hinge part 43 of the support member 40 decreases and the heat dissipation plate 30 moves in parallel along the Z-axis direction so that it comes close to the wall part 81. The heat dissipation plate 30 is supported by the support member 40 in a state in which the heat conductive member 70 adhering to the second facing surface 30A is separated from the first facing surface 13A of the condenser 13, i.e.., in a state in which the heat dissipation plate is not thermally connected to the condenser 13. At this time, since the angle of the hinge part 43 is maintained small by the large repulsive force generated between the first magnet 50 and the second magnet 60, the heat dissipation plate 30 is supported by the support member 40 in the state of being thermally disconnected from the condenser 13. In other words, at the time of the low heat input, the support member 40 is formed to support the heat dissipation plate 30 in a state in which the heat dissipation plate is not thermally connected to the condenser 13. In this way, when the heat dissipation plate 30 and the condenser 13 are in the thermally disconnected state, heat dissipation or cooling by the heat dissipation plate 30 is not performed. Thereby, at the time of the low heat input, it is possible to suppress the heat-generating component 16 and the like from being excessively cooled by the heat dissipation plate 30. For this reason, at the time of the low heat input, the electronic device M1 can be kept warm by using the heat in the loop type heat pipe 10 and the heat-generating component 16 (refer FIG. 3). For example, in a case of using the electronic device M1 in a space environment, it may be required to keep the electronic device M1 warm in a situation in which sunlight is not irradiated. In such a case, according to the electronic device M1 of the present embodiment, at the time of the low heat input, the electronic device M1 can be kept warm by using the heat in the loop type heat pipe 10 and the heat-generating part 16 (refer FIG. 3).

Next, with reference to FIG. 1A, the electronic device M1 at a time of a high heat input in which a heat input amount from the heat-generating component 16 (refer to FIG. 3) to the loop type heat pipe 10 is larger than the first heat amount will be described. Note that, the heat input amount at the time of the high heat input is, for example, a heat amount within a range in which heat dissipation by the heat dissipation plate 30 is required. For example, the heat input amount at the time of the high heat input is a heat amount in which the heat generated by the heat-generating component 16 (refer to FIG. 3) exceeds the heat tolerance of the heat-generating component 16 in a state in which there is no heat dissipation by the heat dissipation plate 30.

At the time of the high heat input, since the heat input amount to the condenser 13 becomes large, the ambient temperature of the first magnet 50 provided in the condenser 13 becomes high. Since the first magnet 50 is exposed to the high temperature, the thermal demagnetization (decrease in magnetic force) in the first magnet 50 becomes larger, as compared with the case of the low heat input. As a result, the repulsive force between the first magnet 50 and the second magnet 60 becomes smaller, as compared with the case of the low heat input. When the repulsive force between the first magnet 50 and the second magnet 60 is weakened in this way, the angle of the hinge part 43 of the support member 40 becomes larger, as compared with the angle at the time of the low heat input, and the heat dissipation plate 30 moves in parallel along the Z-axis direction so that it comes close to the condenser 13. The heat dissipation plate 30 is supported by the support member 40 in a state in which the heat conductive member 70 adhering to the second facing surface 30A is in contact with the first facing surface 13A of the condenser 13, i.e., in a state in which the heat dissipation plate is thermally connected to the condenser 13. At this time, the first end face 70A of the heat conductive member 70 is in contact with the first facing surface 13A of the condenser 13 without a gap, but does not adhere to the first facing surface 13A. In addition, when the repulsive force between the first magnet 50 and the second magnet 60 is small, the angle of the hinge part 43 is maintained large, so that the heat dissipation plate 30 is supported by the support member 40 in a state of being thermally connected to the condenser 13. In other words, at the time of the high heat input, the support member 40 is formed to support the heat dissipation plate 30 in a state in which the heat dissipation plate is thermally connected to the condenser 13. In this way, when the heat dissipation plate 30 and the condenser 13 are in a thermally connected state, a path for heat conduction from the condenser 13 to the heat dissipation plate 30 via the heat conductive member 70 is formed. Thereby, the heat in the condenser 13 can be efficiently dissipated by the heat dissipation plate 30 at the time of the high heat input. For this reason, at the time of the high heat input, it is possible to efficiently cool the heat-generating component 16 (refer FIG. 3), and to favorably suppress the heat generated by the heat-generating component 16 from exceeding the heat tolerance of the heat-generating component 16.

Next, the effects of the present embodiment are described.
(1) The condenser 13 is provided with the first magnet 50, and the heat dissipation plate 30 is provided with the second magnet 60 facing the first magnet 50. In addition, provided is the support member 40 configured to movably support the heat dissipation plate 30 between the state in which the heat dissipation plate 30 is thermally connected to the condenser 13 and the state in which the heat dissipation plate is not thermally connected to the condenser, so as to be able to vary the distance between the condenser 13 and the heat dissipation plate 30, in response to the change in magnetic force of the first magnet 50. According to this configuration, the connection state of the heat dissipation plate 30 to the condenser 13 can be varied, in response to the change in magnetic force of the first magnet 50. Here, in the state in which the heat dissipation plate 30 is not thermally connected to the condenser 13, the heat dissipation (cooling) of the heat-generating component 16 is performed only by the loop type heat pipe 10. In contrast, when the heat dissipation plate 30 is thermally connected to the condenser 13, the density of heat from the condenser 13 can be dispersed by the heat dissipation plate 30. Thereby, the heat dissipation (cooling) of the heat-generating component 16 is performed by the loop type heat pipe 10 and the heat dissipation plate 30. For this reason, as compared with the state in which the heat dissipation plate 30 is not thermally connected to the condenser 13, the heat dissipation performance in the loop type heat pipe 10 and the heat dissipation plate 30 can be improved. Therefore, by varying the connection state of the heat dissipation plate 30 to the condenser 13 in response to the change in magnetic force of the first magnet 50, the heat dissipation performance of the loop type heat pipe 10 can be varied. Here, when the first magnet 50 is exposed to a high temperature, for example, the magnetic force decreases. For this reason, the magnetic force of the first magnet 50 changes, according to the use situation and the use environment of the loop type heat pipe 10. Therefore, by varying the connection state of the heat dissipation plate 30 to the condenser 13 in response to the change in magnetic force of the first magnet 50, it is possible to vary the heat dissipation performance of the loop type heat pipe 10, in response to the use situation and the use environment of the loop type heat pipe 10.
(2) At the time of the low heat input, the heat dissipation plate 30 is supported in the state of being thermally disconnected from the condenser 13, in response to the repulsive force between the first magnet 50 and the second magnet 60. At the time of the high heat input, the heat dissipation plate 30 is supported in the state being thermally connected to the condenser 13, in response to the thermal demagnetization of the first magnet 50. Specifically, at the time of the high heat input, the heat dissipation plate 30 is supported in the state of being thermally connected to the condenser 13, in response to the decrease in repulsive force between the first magnet 50 and the second magnet 60 due to the thermal demagnetization of the first magnet 50. According to this configuration, the heat dissipation performance of the loop type heat pipe 10 can be varied, in response to changes in the use situation and the use environment such as the heat input amount from the heat-generating component 16. For example, at the time of the low heat input, since sufficient heat dissipation performance can be obtained only with the loop type heat pipe 10, the heat dissipation by the heat dissipation plate 30 is not performed. Thereby, at the time of the low heat input, it is possible to suppress the heat-generating component 16 and the like from being excessively cooled by the heat dissipation plate 30. For this reason, at the time of the low heat input, the electronic device M1 can be kept warm by using the heat in the loop type heat pipe 10 and the heat-generating component 16 (refer FIG. 3). On the other hand, at the time of the high heat input, since sufficient heat dissipation performance cannot be obtained only with the loop type heat pipe 10, the heat dissipation by the heat dissipation plate 30 is performed. Thereby, the heat in the condenser 13 can be efficiently dissipated by the heat dissipation plate 30 at the time of the high heat input. For this reason, at the time of the high heat input, the heat-generating component 16 can be efficiently cooled.
(3) The first magnet 50 is provided in the condenser 13 of the loop type heat pipe 10. According to this configuration, the first magnet 50 can be provided in the condenser 13 having a large area for heat dissipation. For this reason, an installation area of the first magnet 50 can be easily and widely secured. Further, the first magnet 50 is provided in the condenser 13, so that heat can be efficiently dissipated to the heat dissipation plate 30.
(4) The heat conductive member 70 is interposed between the first facing surface 13A of the condenser 13 and the second facing surface 30A of the heat dissipation plate 30. The heat conductive member 70 can reduce a contact thermal resistance between the first facing surface 13A and the second facing surface 30A, and can smoothly conduct heat from the condenser 13 to the heat dissipation plate 30. For this reason, when the heat dissipation plate 30 is connected to the condenser 13 via the heat conductive member 70, the heat in the condenser 13 can be efficiently heat-conducted to the heat dissipation plate 30 via the heat conductive member 70.
(5) The first end face 70A of the heat conductive member 70 is formed as the non-adhesive surface, and the second end face 70B of the heat conductive member 70 is formed as the adhesive surface. According to this configuration, for example, the second end face 70B of the heat conducting member 70 adheres to the second facing surface 30A of the heat dissipation plate 30, and the first end face 70A of the heat conducting member 70 does not adhere to the first facing surface 13 A of the condenser 13. In this way, since any one of the condenser 13 and the heat dissipation plate 30, here, the condenser 13 and the heat conductive member 70 do not adhere to each other, the heat dissipation plate 30 can be favorably moved so that the heat dissipation plate 30 and the condenser 13 are not thermally connected to each other.
(6) The first magnet 50 is embedded in the condenser 13. According to this configuration, it is possible to favorably suppress the increase in size of the loop type heat pipe 10 in the Z-axis direction due to the first magnet 50 provided.
(7) The first magnet 50 is formed to penetrate through the condenser 13 in the thickness direction. According to this configuration, the thickness of the first magnet 50 can be easily formed to be thick.

### (Other Embodiments)

The above embodiment can be changed and implemented, as follows. The above embodiment and the following modified embodiments can be implemented in combination with each other within a technically consistent range.

In the above embodiment, the first magnet 50 is formed to penetrate through the condenser 13 in the thickness direction. However, the present invention is not limited thereto.

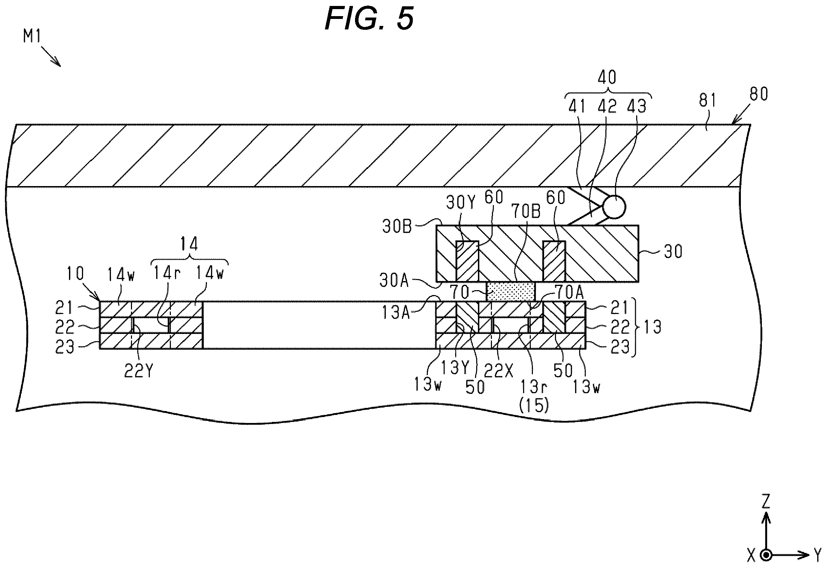

For example, as shown in FIG. 5, the first magnet 50 may be formed so as not to penetrate through the condenser 13 in the thickness direction. In this case, for example, the pipe wall 13w of the condenser 13 is provided with a plurality of concave portions 13Y. Each concave portion 13Y is formed so as not to penetrate through the condenser layer 13 in the thickness direction. Each concave portion 13Y is formed to be concave from the first facing surface 13A toward the lower surface of the condenser 13, for example. Each concave portion 13Y is formed to penetrate through the metal layers 21 and 22 among the metal layers 21, 22 and 23 in the thickness direction, for example. Each of the first magnets 50 is accommodated in each concave portion 13Y. The side surface of each of the first magnets 50 is in close contact with an inner surface of each concave portion 13Y, for example. Note that, the side surface of each of the first magnets 50 and the inner surface of each concave portion 13Y may be in direct contact with each other or may be in contact with each other via an adhesive member or the like.

A depth of the concave portion 13Y shown in FIG. 5 can be changed as appropriate. For example, the concave portion 13Y may be formed to penetrate through the metal layer 21 among the metal layers 21, 22 and 23 in the thickness direction.

The concave portion 13Y shown in FIG. 5 may be formed to be concave from the lower surface of the condenser 13, i.e., the lower surface of the metal layer 23 toward the first facing surface 13 A.

In the above embodiment, the second magnet 60 is formed to penetrate through the heat dissipation plate 30 in the thickness direction. However, the present invention is not limited thereto.

For example, as shown in FIG. 5, the second magnet 60 may be formed so as not to penetrate through the heat dissipation plate 30 in the thickness direction. In this case, for example, the heat dissipation plate 30 is provided with a plurality of concave portions 30Y Each concave portion 30Y is formed so as not to penetrate through the heat dissipation plate 30 in the thickness direction. Each concave portion 30Y is formed to be concave from the second facing surface 30A toward the opposite surface 30B, for example. A bottom surface of each concave portion 30Y is provided in the middle of the heat dissipation plate 30 in the thickness direction. Each of the second magnets 60 is accommodated in each concave portion 30Y. The side surface of each of the second magnets 60 is in close contact with an inner surface of each concave portion 30Y, for example. Note that, the side surface of each of the second magnets 60 and the inner surface of each concave portion 30Y may be in direct contact with each other or may be in contact with each other via an adhesive member or the like.

A depth of the concave portion 30Y shown in FIG. 5 can be changed as appropriate.

The concave portion 30Y shown in FIG. 5 may be formed to be concave from the opposite surface 30B toward the second facing surface 30A.

In the above embodiment, the upper surface of the first magnet 50 is formed to be flush with the first facing surface 13A. However, the present invention is not limited thereto.

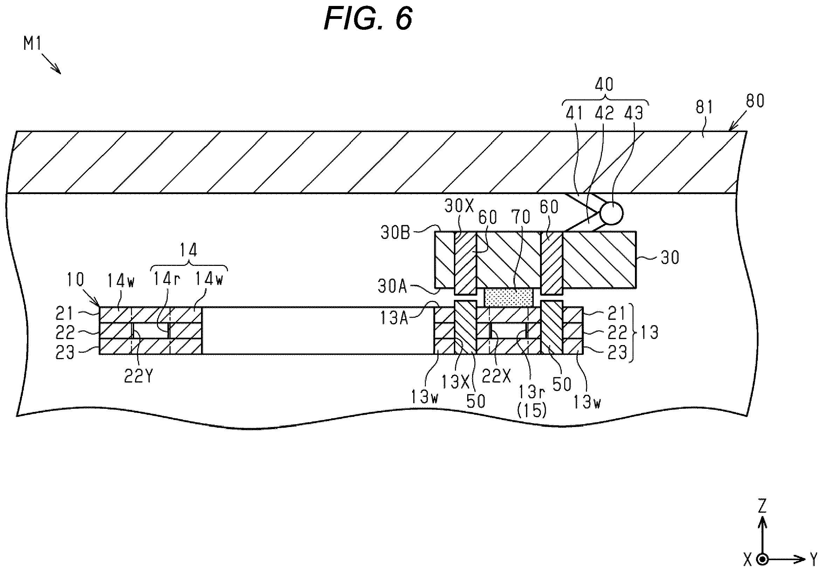

For example, as shown in FIG. 6, the first magnet 50 may be formed to protrude toward the second facing surface 30A from the first facing surface 13A. In this case, the upper part of the first magnet 50 protrudes upward from the first facing surface 13A. At this time, a protrusion amount of the first magnet 50 from the first facing surface 13A is set to be smaller than the thickness of the heat conductive member 70. Thereby, even when the first magnet 50 protrudes upward from the first facing surface 13A, the condenser 13 and the heat dissipation plate 30 can be favorably thermally connected to each other via the heat conductive member 70.

In the above embodiment, the lower surface of the second magnet 60 is formed to be flush with the second facing surface 30A. However, the present invention is not limited thereto.

For example, as shown in FIG. 6, the second magnet 60 may be formed to protrude toward the first facing surface 13A from the second facing surface 30A. In this case, the lower part of the second magnet 60 protrudes downward from the second facing surface 30A. At this time, a protrusion amount of the second magnet 60 from the second facing surface 30A is set to be smaller than the thickness of the heat conductive member 70. Further, in the modified embodiment shown in FIG. 6, a total amount obtained by summing the protrusion amount of the first magnet 50 from the first facing surface 13A and the protrusion amount of the second magnet 60 from the second facing surface 30A is set to be smaller than the thickness of the heat conductive member 70. Thereby, even when the first magnet 50 protrudes from the first facing surface 13A and the second magnet 60 protrudes from the second facing surface 30A, the condenser 13 and the heat dissipation plate 30 can be favorably thermally connected to each other via the heat conductive member 70.

In the above embodiment, the lower surface of the first magnet 50 is formed to be flush with the lower surface of the condenser 13. However, the present invention is not limited thereto. For example, the lower part of the first magnet 50 may be formed to protrude downward from the lower surface of the condenser 13. In addition, for example, the lower part of the first magnet 50 may be formed to be located closer to the first facing surface 13A side than the lower surface of the condenser 13.

In the above embodiment, the upper surface of the second magnet 60 is formed to be flush with the opposite surface 30B of the heat dissipation plate 30. However, the present invention is not limited thereto. For example, the upper part of the second magnet 60 may be formed to protrude upward from the opposite surface 30B. In addition, for example, the upper part of the second magnet 60 may be formed to be located closer to the second opposite surface 30A side than the opposite surface 30B.

In the above embodiment, the first magnet 50 is provided embedded in the condenser 13. However, the present invention is not limited thereto. For example, the first magnet 50 may be provided on an outer surface of the condenser 13.

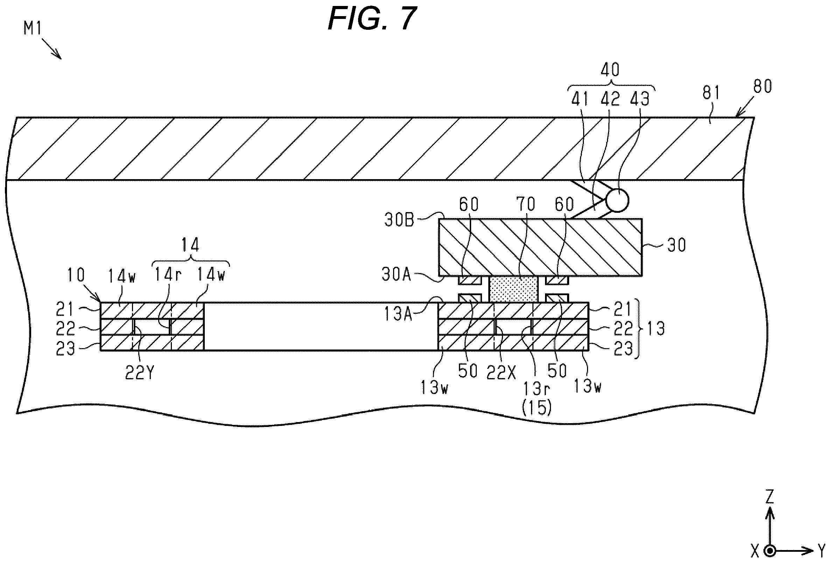

For example, as shown in FIG. 7, the first magnet 50 may be provided on the first facing surface 13A of the condenser 13. In this case, the thickness of the first magnet 50 is formed thinner than the thickness of the heat conductive member 70. In addition, the first magnet 50 of the present modified embodiment is provided so as not to overlap the heat conductive member 70 in the top view. Thereby, even when the first magnet 50 is provided on the first facing surface 13A, the condenser 13 and the heat dissipation plate 30 can be favorably thermally connected to each other via the heat conductive member 70.

In the above embodiment, the second magnet 60 is provided embedded in the heat dissipation plate 30. However, the present invention is not limited thereto. For example, the second magnet 60 may be provided on an outer surface of the heat dissipation plate 30.

For example, as shown in FIG. 7, the second magnet 60 may be provided on the second facing surface 30A of the heat dissipation plate 30. In this case, the thickness of the second magnet 60 is formed thinner than the thickness of the heat conductive member 70. In addition, the second magnet 60 of the present modified embodiment is provided so as not to overlap the heat conductive member 70 in the top view. Further, in the modified embodiment shown in FIG. 7, a total thickness obtained by summing the thickness of the first magnet 50 provided on the first facing surface 13A and the thickness of the second magnet 60 provided on the second facing surface 30A is formed to be smaller than the thickness of the heat conductive member 70. Thereby, even when the first magnet 50 is provided on the first facing surface 13A and the second magnet 60 is provided on the second facing surface 30A, the condenser 13 and the heat dissipation plate 30 can be favorably thermally connected to each other via the heat conductive member 70.

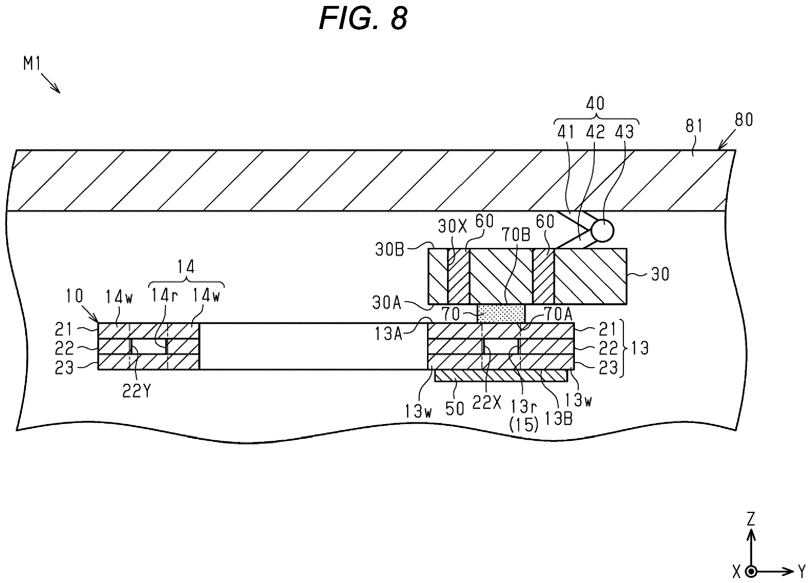

For example, as shown in FIG. 8, the first magnet 50 may be provided on a lower surface 13B of the condenser 13. In this case, the first magnet 50 may be provided to overlap the flow path 13r in the top view. In addition, the first magnet 50 may be provided to overlap the heat conductive member 70 in the top view. Further, the first magnet 50 may be provided to partially overlap the second magnet 60 in the top view.

In the above embodiment, the condenser 13 and the heat dissipation plate 30 are thermally connected to each other via the heat conductive member 70. However, the present invention is not limited thereto.

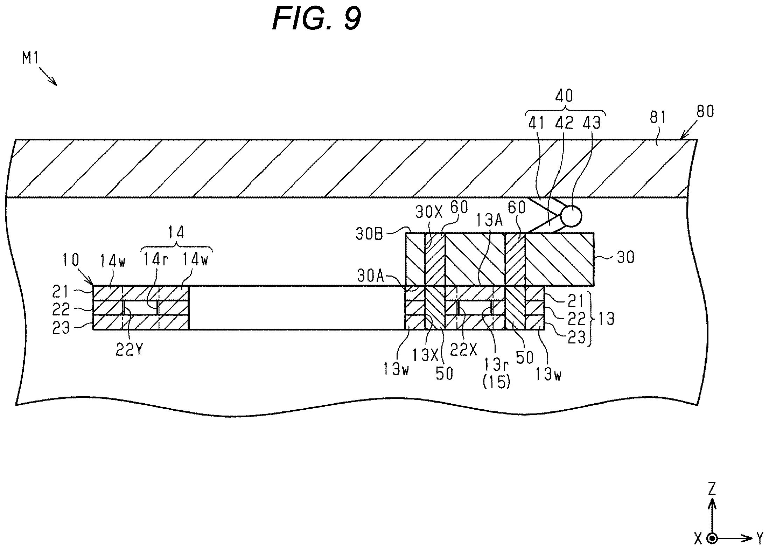

For example, as shown in FIG. 9, the condenser 13 and the heat dissipation plate 30 may be thermally connected to each other by directly bringing the first facing surface 13 A of the condenser 13 and the second facing surface 30A of the heat dissipation plate 30 into contact with each other. In this case, the heat conductive member 70 is omitted.

The planar shape of the first magnet 50 in the above embodiment is not particularly limited. For example, the planar shape of the first magnet 50 may be formed in an arbitrary shape such as a polygonal shape, a semicircular shape, or an elliptical shape.

The planar shape of the second magnet 60 in the above embodiment is not particularly limited. For example, the planar shape of the second magnet 60 may be formed in an arbitrary shape such as a polygonal shape, a semicircular shape, or an elliptical shape.

The shape of the flow path 13r in the condenser 13 of the above embodiment is not particularly limited.

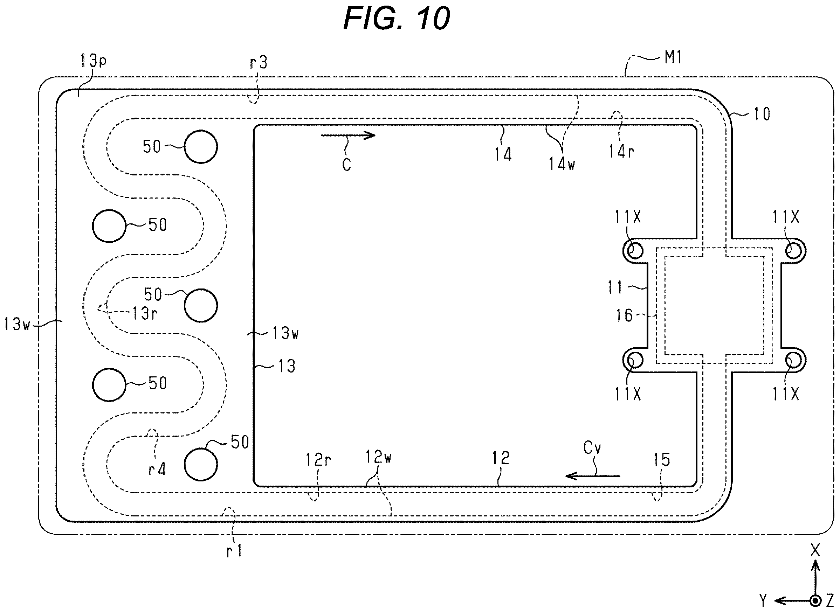

For example, as shown in FIG. 10, the flow path 13r may be formed in a shape having a serpentine part r4 meandering in an XY plane. The flow path 13r of the present modified embodiment has a flow path r1 extending in the Y-axis direction, a serpentine part r4 extending in the X-axis direction while meandering from an end portion of the flow path r1, and a flow path r3 extending from an end portion of the serpentine part r4 in the Y-axis direction. The first magnet 50 of the present modified embodiment is provided so as not to overlap the flow path 13r, for example, in the top view.

In the above embodiment, the first magnets 50 are provided on both sides of the pair of pipe walls 13w of the condenser 13. However, the present invention is not limited thereto. For example, the first magnet 50 may be provided only in one pipe wall 13w of the pair of pipe walls 13w.

In the above embodiment, the plurality of first magnets 50 may be formed in different shapes from each other.

In the above embodiment, the plurality of second magnets 60 may be formed in different shapes from each other.

In the above embodiment, the first magnet 50 and the second magnet 60 may be formed in different shapes from each other.

In the above embodiment, the first magnet 50 is provided in the condenser 13 of the loop type heat pipe 10, and the heat dissipation plate 30 is thermally connected to the condenser 13. However, the present invention is not limited thereto. For example, the first magnet 50 may be provided in the liquid pipe 14 and the heat dissipation plate 30 may be thermally connected to the liquid pipe 14. For example, the first magnet 50 may be provided in the vapor pipe 12, and the heat dissipation plate 30 may be thermally connected to the vapor pipe 12.

In the loop type heat pipe 10 of the above embodiment, the inner metal layer is configured only by the metal layer 22 of a single layer. That is, the inner metal layer is formed to have a single layer structure. However, the present invention is not limited thereto. For example, the inner metal layer may also be formed to have a stacked structure where a plurality of metal layers is stacked. In this case, the inner metal layer is configured by a plurality of metal layers stacked between the metal layer 21 and the metal layer 23.

The structure of the support member 40 of the above embodiment can be appropriately changed. For example, the structure of the support member 40 is not particularly limited as long as the support member has a structure capable of movably supporting the heat dissipation plate 30 so that the distance between the outer surface of the loop type heat pipe 10 and the heat dissipation plate 30 can be varied, in response to the change in magnetic force of the first magnet 50. For example, the support member 40 may be configured by a spring member.

## Claims

1. An electronic device (M1) comprising:
a loop type heat pipe (10) including a loop-shaped flow path (15, 13r) in which a working fluid is enclosed;
**characterised by**
a first magnet (50) provided to the loop type heat pipe (10);
a heat dissipation plate (30) thermally connectable to the loop type heat pipe (10);
a second magnet (60) provided to the heat dissipation plate (30) and provided to face the first magnet (50); and
a support member (40) that movably supports the heat dissipation plate (30) so that a distance between the loop type heat pipe (10) and the heat dissipation plate (30) can be varied in response to a change in magnetic force of the first magnet (50).

2. The electronic device according to Claim 1, wherein the first magnet (50) and the second magnet (60) are provided so that the same magnetic poles face to each other,
wherein the support member (40) is configured to support the heat dissipation plate (30) in the state in which the heat dissipation plate (30) is not thermally connected to the loop type heat pipe (10), in response to a repulsive force between the first magnet (50) and the second magnet (60), during the time when a heat amount input to the loop type heat pipe (10) is equal to or less than a first heat amount, and
wherein the support member (40) is configured to support the heat dissipation plate (30) in the state in which the heat dissipation plate (30) is thermally connected to the loop type heat pipe (10), in response to thermal demagnetization of the first magnet (50), during the time when the heat amount input to the loop type heat pipe (10) is larger than the first heat amount.

3. The electronic device according to Claim 1 or 2, wherein the loop type heat pipe (10) comprises:
an evaporator (11) that vaporizes the working fluid,
a condenser (13) that condenses the working fluid,
a liquid pipe (14) that connects the evaporator (11) and the condenser (13) to each other, and
a vapor pipe (12) that connects the evaporator (11) and the condenser (13) to each other,
wherein the first magnet (50) is provided to the condenser (13), and
wherein the heat dissipation plate (30) is thermally connectable to the condenser (13).

4. The electronic device according to Claim 3, further comprising:
a heat conductive member (70),
wherein the condenser (13) has a first facing surface (13A) facing the heat dissipation plate (30),
wherein the heat dissipation plate (30) has a second facing surface (30A) facing the first facing surface (13A),
wherein the heat conductive member (70) is provided between the first facing surface (13A) and the second facing surface (30A), and
wherein the heat dissipation plate (30) is thermally connectable to the condenser (13) via the heat conductive member (70).

5. The electronic device according to Claim 4, wherein the heat conductive member (70) has a first end face (70A) and a second end face (70B) in a thickness direction of the heat conductive member (70),
wherein the first end face (70A) faces the first facing surface (13A), and the second end face (70B) faces the second facing surface (30A),
wherein one of the first end face (70A) the second end face (70B) is a non-adhesive surface, and
wherein the other of the first end face (70A) and the second end face (70B) is an adhesive surface.

6. The electronic device according to Claim 4 or 5, wherein the first magnet (50) is provided to protrude toward the second facing surface (30A) from the first facing surface (13A), and
wherein a protrusion amount of the first magnet (50) from the first facing surface (13A) is smaller than a thickness of the heat conductive member (70) in a direction in which the first facing surface (13A) and the second facing surface (30A) face to each other.

7. The electronic device according to Claim 6, wherein the second magnet (60) is provided to protrude toward the first facing surface (13A) from the second facing surface (30A), and
wherein a total amount obtained by summing a protrusion amount of the first magnet (50) from the first facing surface (13A) and a protrusion amount of the second magnet (60) from the second facing surface (30A) is smaller than the thickness of the heat conductive member (70).

8. The electronic device according to any one of Claims 4 to 7, wherein the first magnet (50) is provided at a position not overlapping the heat conductive member (70), as seen from a direction in which the first magnet (50) and the second magnet (60) face to each other.

9. The electronic device according to any one of Claims 3 to 8, wherein the first magnet (50) is provided so as not to overlap the flow path (13r, 15), as seen from a direction in which the first magnet (50) and the second magnet face (60) to each other, and
wherein the first magnet (50) is embedded in the condenser (13).

10. The electronic device according to any one of Claims 3 to 9, wherein the first magnet (50) is provided to penetrate through the condenser (13) in a direction in which the first magnet (50) and the second magnet (60) face to each other.

## Patentansprüche

1. Elektronische Vorrichtung (M1), aufweisend:
eine Kreislaufwärmeleitung (10) mit einem schleifenförmigen Strömungspfad (15, 13r), in dem eine Betriebsflüssigkeit eingeschlossen ist; **gekennzeichnet durch**
einen ersten Magneten (50), der an der Kreislaufwärmeleitung (10) vorgesehen ist;
eine Wärmeableitungsplatte (30), die mit der Kreislaufwärmeleitung (10) thermisch verbindbar ist;
einen zweiten Magneten (60), der an der Wärmeableitungsplatte (30) vorgesehen ist und dem ersten Magneten (50) zugewandt ist; und
ein Trägerelement (40), das die Wärmeableitungsplatte (30) beweglich trägt, sodass ein Abstand zwischen der Kreislaufwärmeleitung (10) und der Wärmeableitungsplatte (30) in Reaktion auf eine Änderung der Magnetkraft des ersten Magneten (50) variiert werden kann.

2. Elektronische Vorrichtung nach Anspruch 1, wobei der erste Magnet (50) und der zweite Magnet (60) so vorgesehen sind, dass die gleichen Magnetpole einander zugewandt sind,
wobei das Trägerelement (40) derart konfiguriert ist, dass es die Wärmeableitungsplatte (30) in dem Zustand trägt, in welchem die Wärmeableitungsplatte (30) in Reaktion auf eine Abstoßungskraft zwischen dem ersten Magneten (50) und dem zweiten Magneten (60) während der Zeit, in der eine der Kreislaufwärmeleitung (10) zugeführte Wärmemenge gleich oder kleiner als eine erste Wärmemenge ist, nicht thermisch mit der Kreislaufwärmeleitung (10) verbunden ist, und
wobei das Trägerelement (40) derart konfiguriert ist, dass es die Wärmeableitungsplatte (30) in dem Zustand trägt, in welchem die Wärmeableitungsplatte (30) in Reaktion auf die thermische Entmagnetisierung des ersten Magneten (50) während der Zeit, in der die der Kreislaufwärmeleitung (10) zugeführte Wärmemenge größer als die erste Wärmemenge ist, thermisch mit der Kreislaufwärmeleitung (10) verbunden ist.

3. Elektronische Vorrichtung nach Anspruch 1 oder 2, wobei die Kreislaufwärmeleitung (10) aufweist:
einem Verdampfer (11), der die Betriebsflüssigkeit verdampft,
einen Kondensator (13), der die Betriebsflüssigkeit kondensiert,
eine Flüssigkeitsleitung (14), die den Verdampfer (11) und den Kondensator (13) miteinander verbindet, und
eine Dampfleitung (12), die den Verdampfer (11) und den Kondensator (13) miteinander verbindet,
wobei der erste Magnet (50) am Kondensator (13) vorgesehen ist, und
wobei die Wärmeableitungsplatte (30) mit dem Kondensator (13) thermisch verbindbar ist.

4. Elektronische Vorrichtung nach Anspruch 3, weiterhin aufweisend:
ein wärmeleitendes Element (70),
wobei der Kondensator (13) eine erste zugewandte Fläche (13A) hat, die der Wärmeabgabeplatte (30) zugewandt ist,
wobei die Wärmeableitungsplatte (30) eine zweite zugewandte Fläche (30A) hat, die der ersten zugewandten Fläche (13A) zugewandt ist,
wobei das wärmeleitende Element (70) zwischen der ersten zugewandten Fläche (13A) und der zweiten zugewandten Fläche (30A) vorgesehen ist, und
wobei die Wärmeableitungsplatte (30) mittels des wärmeleitenden Elements (70) mit dem Kondensator (13) thermisch verbindbar ist.

5. Elektronische Vorrichtung nach Anspruch 4, wobei das wärmeleitende Element (70) eine erste Endfläche (70A) und eine zweite Endfläche (70B) in einer Dickenrichtung des wärmeleitenden Elements (70) aufweist,
wobei die erste Endfläche (70A) der ersten zugewandten Fläche (13A) zugewandt ist, und die zweite Endfläche (70B) der zweiten zugewandten Fläche (30A) zugewandt ist,
wobei eine der ersten Endfläche (70A) und der zweiten Endfläche (70B) eine nicht klebende Fläche ist, und
wobei die andere der ersten Endfläche (70A) und der zweiten Endfläche (70B) eine Klebefläche ist.

6. Elektronische Vorrichtung nach Anspruch 4 oder 5, wobei der erste Magnet (50) so vorgesehen ist, dass er von der ersten zugewandten Fläche (13A) in Richtung der zweiten zugewandten Fläche (30A) vorsteht, und
wobei ein Vorsprungsmaß des ersten Magneten (50) von der ersten zugewandten Fläche (13A) kleiner ist als eine Dicke des wärmeleitenden Elements (70) in einer Richtung, in der die erste zugewandte Fläche (13A) und die zweite zugewandte Fläche (30A) einander gegenüberliegen.

7. Elektronische Vorrichtung nach Anspruch 6, wobei der zweite Magnet (60) so vorgesehen ist, dass er von der zweiten zugewandten Fläche (30A) in Richtung der ersten zugewandten Fläche (13A) vorsteht, und
wobei ein Gesamtmaß, das sich durch Summieren eines Vorsprungsmaßes des ersten Magneten (50) von der ersten zugewandten Fläche (13A) und eines Vorsprungsmaßes des zweiten Magneten (60) von der zweiten zugewandten Fläche (30A) ergibt, kleiner ist als die Dicke des wärmeleitenden Elements (70).

8. Elektronische Vorrichtung nach einem der Ansprüche 4 bis 7, wobei der erste Magnet (50) an einer Position vorgesehen ist, die das wärmeleitende Element (70) nicht überlappt, gesehen aus einer Richtung, in der der erste Magnet (50) und der zweite Magnet (60) einander zugewandt sind.

9. Elektronische Vorrichtung nach einem der Ansprüche 3 bis 8, wobei der erste Magnet (50) so vorgesehen ist, dass er den Strömungspfad (13r, 15) nicht überlappt, gesehen aus einer Richtung, in der der erste Magnet (50) und der zweite Magnet (60) einander zugewandt sind, und
wobei der erste Magnet (50) in den Kondensator (13) eingebettet ist.

10. Elektronische Vorrichtung nach einem der Ansprüche 3 bis 9, wobei der erste Magnet (50) so vorgesehen ist, den Kondensator (13) in einer Richtung zu durchdringen, in der der erste Magnet (50) und der zweite Magnet (60) einander zugewandt sind.

## Revendications

1. Dispositif électronique (M1) comprenant :
un caloduc en forme de boucle (10) comportant un trajet d'écoulement en forme de boucle (15, 13r) dans lequel un fluide de travail est enfermé ;
**caractérisé par**
un premier aimant (50) fourni au caloduc en forme de boucle (10) ;
une plaque de dissipation de chaleur (30) pouvant être thermiquement reliée au caloduc en forme de boucle (10) ;
un deuxième aimant (60) fourni à la plaque de dissipation de chaleur (30) et fourni pour faire face au premier aimant (50) ; et
un élément de support (40) qui supporte de façon mobile la plaque de dissipation de chaleur (30) de sorte qu'une distance entre le caloduc en forme de boucle (10) et la plaque de dissipation de chaleur (30) puisse être amenée à varier en réponse à un changement de force magnétique du premier aimant (50).

2. Dispositif électronique selon la revendication 1, dans lequel le premier aimant (50) et le deuxième aimant (60) sont fournis de sorte que les mêmes pôles magnétiques se fassent face,
dans lequel l'élément de support (40) est configuré pour supporter la plaque de dissipation de chaleur (30) dans l'état dans lequel la plaque de dissipation de chaleur (30) n'est pas thermiquement reliée au caloduc en forme de boucle (10), en réponse à une force de répulsion entre le premier aimant (50) et le deuxième aimant (60), pendant le temps pendant le lequel une entrée de quantité de chaleur dans le caloduc en forme de boucle (10) est égale ou inférieure à la première quantité de chaleur, et
dans lequel l'élément de support (40) est configuré pour supporter la plaque de dissipation de chaleur (30) dans l'état dans lequel la plaque de dissipation de chaleur (30) est thermiquement reliée au caloduc en forme de boucle (10), en réponse à une démagnétisation thermique du premier aimant (50), pendant le temps pendant lequel l'entrée de quantité de chaleur dans le caloduc en forme de boucle (10) est supérieure à la première quantité de chaleur.

3. Dispositif électronique selon la revendication 1 ou 2, dans lequel le caloduc en forme de boucle (10) comprend :
un évaporateur (11) qui vaporise le fluide de travail,
un condenseur (13) qui condense le fluide de travail,
une conduite de liquide (14) qui relie l'évaporateur (11) et le condenseur (13) l'un à l'autre, et
une conduite de vapeur (12) qui relie l'évaporateur (11) et le condenseur (13) l'un à l'autre,
dans lequel le premier aimant (50) est fourni au condenseur (13), et
dans lequel la plaque de dissipation de chaleur (30) peut être thermiquement reliée au condenseur (13).

4. Dispositif électronique selon la revendication 3, comprenant en outre :
un élément conducteur de chaleur (70),
dans lequel le condenseur (13) présente une première surface de face (13A) faisant face à la plaque de dissipation de chaleur (30),
dans lequel la plaque de dissipation de chaleur (30) présente une deuxième surface de face (30A) faisant face à la première surface de face (13A),
dans lequel l'élément conducteur de chaleur (70) est fourni entre la première surface de face (13A) et la deuxième surface de face (30A), et
dans lequel la plaque de dissipation de chaleur (30) peut être thermiquement reliée au condenseur (13) par l'intermédiaire de l'élément conducteur de chaleur (70).

5. Dispositif électronique selon la revendication 4, dans lequel l'élément conducteur de chaleur (70) présente une première face d'extrémité (70A) et une deuxième face d'extrémité (70B) dans une direction d'épaisseur de l'élément conducteur de chaleur (70),
dans lequel la première face d'extrémité (70A) fait face à la première surface de face (13A), et la deuxième face d'extrémité (70B) fait face à la deuxième surface de face (30A),
dans lequel l'une de la première face d'extrémité (70A) et de la deuxième face d'extrémité (70B) est une surface non adhésive, et
dans lequel l'autre de la première face d'extrémité (70A) et de la deuxième face d'extrémité (70B) est une surface adhésive.

6. Dispositif électronique selon la revendication 4 ou 5, dans lequel le premier aimant (50) est fourni pour faire saillie en direction de la deuxième surface de face (30A) depuis la première surface de face (13A), et
dans lequel une quantité de saillie du premier aimant (50) depuis la première surface de face (13A) est inférieure à une épaisseur de l'élément conducteur de chaleur (70) dans une direction dans laquelle la première surface de face (13A) et la deuxième surface de face (30A) se font face.

7. Dispositif électronique selon la revendication 6, dans lequel le deuxième aimant (60) est fourni pour faire saillie en direction de la première surface de face (13A) depuis la deuxième surface de face (30A), et
dans lequel une quantité totale obtenue en additionnant une quantité de saillie du premier aimant (50) depuis la première surface de face (13A) et une quantité de saillie du deuxième aimant (60) depuis la deuxième surface de face (30A) est inférieure à l'épaisseur de l'élément conducteur de chaleur (70).

8. Dispositif électronique selon l'une quelconque des revendications 4 à 7, dans lequel le premier aimant (50) est fourni au niveau d'une position ne chevauchant pas l'élément conducteur de chaleur (70), vu depuis une direction dans laquelle le premier aimant (50) et le deuxième aimant (60) se font face.

9. Dispositif électronique selon l'une quelconque des revendications 3 à 8, dans lequel le premier aimant (50) est fourni de manière à ne pas chevaucher le trajet d'écoulement (13r, 15), vu depuis une direction dans laquelle le premier aimant (50) et le deuxième aimant (60) se font face, et
dans lequel le premier aimant (50) est incorporé dans le condenseur (13).

10. Dispositif électronique selon l'une quelconque des revendications 3 à 9, dans lequel le premier aimant (50) est fourni pour pénétrer à travers le condenseur (13) dans une direction dans laquelle le premier aimant (50) et le deuxième aimant (60) se font face.
